# EUROPÄISCHE PATENTANMELDUNG

(11) **EP 1 130 654 A1**
(43) Veröffentlichungstag der Anmeldung: **05.09.2001**
(21) Anmeldenummer: 00104264.7
(22) Anmeldetag: 01.03.2000
(51) Int. Cl.: H01L 29/92, H01L 21/02

(54) **Integriertes Bauelement mit Metall-Isolator-Metall-Kondensator**

(71) Anmelder: Infineon Technologies AG, 81669 München (DE)
(72) Erfinder: Schrenk, Michael, 86911 Diessen (DE); Schwerd, Markus, 83607 Holzkirchen (DE)
(74) Vertreter: Zimmermann & Partner

(57) **Zusammenfassung**

Zur Herstellung eines integrierten Bauelements mit integrierten Metall-Isolator-Metall-Kondensators (7) wird zunächst auf eine untere Elektrode (6) aus Kupfer eine dielektrische Zwischenschicht (11) und eine obere Elektrode (12) ganzflächig abgeschieden. Anschließend erfolgt die Strukturierung des Metall-Isolator-Metall-Kondensators (7) mit Ätzstop in der dielektrischen Zwischenschicht (11). Dadurch werden Kurzschlüsse zwischen der oberen Elektrode (12) und der unteren Elektrode (6) vermieden.

## Beschreibung

Die Erfindung betrifft ein integriertes Bauelement mit Leiterbahnen aus einer kupferhaltigen Legierung und einem Metall-Isolator-Metall-Kondensator.

Hochfrequenzschaltungen in BIPOLAR-, BICMOS- und CMOS-Technologie benötigen integrierte Kondensatoren mit hoher Spannungslinearität, genau einstellbaren Kapazitätswerten und vor allem niedrigen parasitären Kapazitäten. Die bisher eingesetzten konventionellen MOS-Kondensatoren weisen aufgrund spannungsinduzierter Raumladungszonen eine ungenügende Spannungslinearität auf. Der geringe Abstand zum Substrat bringt außerdem zahlreiche parasitäre Kapazitäten mit sich. Diese Schwierigkeiten lassen sich durch den Einsatz sogenannter Metall-Isolator-Metall-Kondensatoren (MIM-Kondensatoren) umgehen. Diese Metall-Isolator-Metall-Kondensatoren sollen möglichst ohne Veränderung und Beeinflussung der benachbarten Leiterbahnen in die vorhandenen Konzepte für eine Mehrlagenmetallisierung integriert werden.

Derzeit ist kein Konzept zur Integration von Metall-Isolator-Metall-Kondensatoren in integrierte Bauelemente mit kupferhaltigen Leiterbahnen bekannt.

Ausgehend von diesem Stand der Technik liegt der Erfindung die Aufgabe zugrunde, ein integriertes Bauelement mit Leiterbahnen aus einer kupferhaltigen Legierung und einem integrierten Metall-Isolator-Metall-Kondensator zu schaffen und ein Verfahren zu dessen Herstellung anzugeben.

Diese Aufgabe wird durch ein integriertes Bauelement nach Anspruch 1 und ein Verfahren nach Anspruch 10 gelöst.

Der Metall-Isolator-Metall-Kondensator weist eine Elektrode auf, die in einer Metallebene für Leiterbahn ausgebildet ist. Da die dielektrische Zwischenschicht und die Metallisierungsschicht dünn gehalten werden kann, kann der Metall-Isolator-Metall-Kondensator ohne große Schwierigkeiten in ein bestehendes Konzept zur Herstellung eines integrierten Bauelements mit passiven Bauelementen integriert werden.

Bei der Herstellung des Metall-Isolator-Metall-Kondensators dient die dielektrische Zwischenschicht zweckmäßigerweise als Ätzstop. Dadurch ist gewährleistet, daß die darunterliegende kupferhaltige Elektroden nicht vom Ätzmedium angegriffen wird. Da außerdem die als Ätzstop dienende, dielektrische Zwischenschicht nicht vollständig entfernt wird, werden Kurzschlüsse zwischen der Metallisierungsschicht und der darunterliegenden Elektrode vermieden.

Zweckmäßigerweise wird der Metall-Isolator-Metall-Kondensator dadurch hergestellt, daß auf die freiliegende Elektrode in der Metallebene für Leiterbahnen zunächst eine als Ätzstop dienende dielektrische Zwischenschicht und dann eine Metallisierungsschicht ganzflächig abgeschieden werden. In der anschließenden Strukturierung der Metallisierungsschicht dient die dielektrische Zwischenschicht als Ätzstop und bleibt daher im wesentlichen ganzflächig erhalten. Dadurch werden Kurzschlüsse an den Rändern des Metall-Isolators-Metall-Kondensators wirksam unterdrückt.

Weitere Ausgestaltungen der Erfindung sind Gegenstand der abhängigen Ansprüche.

Nachfolgend wird ein Ausführungsbeispiel der Erfindung anhand der beigefügten Zeichnung erläutert. Es zeigt:

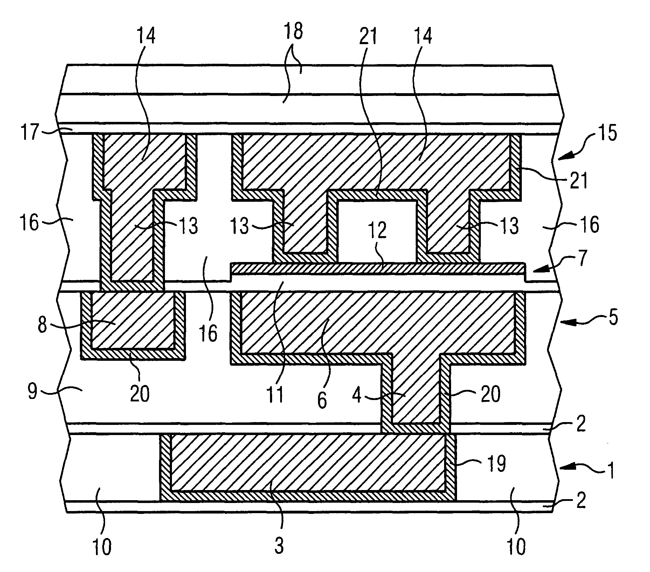

- Figur 1: einen Ausschnitt aus einem Querschnitt durch ein integriertes Bauelement mit einem integrierten Metall-Isolator-Metall-Kondensator.

Figur 1 zeigt einen Ausschnitt aus einem Querschnitt durch diejenigen Schichten, die üblicherweise die passiven Bauelemente einer integrierten Schaltung enthalten. In einer ersten Metallebene 1 sind zwischen nichtleitenden Diffusionsbarrieren 2 Leiterbahnen 3 angeordnet. Über ein Via 4 ist die Leiterbahn 3 mit einer in einer zweiten Metallebene 5 angeordneten unteren Elektrode 6 eines Metall-Isolator-Metall-Kondensators 7 verbunden. In dem Ausschnitt der Figur 1 befindet sich in der Metallebene 5 neben der unteren Elektrode 6 eine weitere Leiterbahn 8. Die Leiterbahn 8 und die untere Elektrode 6 sind in ein Zwischenlagendielektrikum 9 eingebettet. Zweckmäßigerweise handelt es sich dabei um das gleiche Material, das als Trenndielektrikum 10 in der Metallebene 1 die Leiterbahnen 3 gegeneinander isoliert. Auf die untere Elektrode 6 ist eine dielektrische Zwischenschicht 11 aufgebracht, auf der sich eine Metallisierungsschicht befindet, die die obere Elektrode 12 bildet. Die dielektrische Zwischenschicht 11 weist im Bereich des Metall-Isolator-Metall-Kondensators 7 eine größere Dicke auf als außerhalb des Metall-Isolator-Metall-Kondensator 7 und erstreckt sich ganzflächig auf dem Zwischenlagendielektrikum 9.

Die obere Elektrode 12 des Metall-Isolator-Metall-Kondensators 7 und die Leiterbahn 3 sind über Vias 13 mit Leiterbahnen 14 in einer dritten Metallebene 15 verbunden. Die obere Elektrode 12, die Vias 13 und die Leiterbahnen 14 in der dritten Metallebene 15 befinden sich in einem Zwischenlagendielektrikum 16. Oberhalb der dritten Metallebene 15 befindet sich schließlich eine weitere nichtleitende Diffusionsbarriere 17 und weitere Abdeckschichten 18.

Die Leiterbahnen 3, 8 und 14, die untere Elektrode 5 sowie die Vias 4 und 13 sind aus einer kupferhaltigen Legierung, vorzugsweise aus reinem Kupfer. Zur Herstellung der Leiterbahnen 3, 8 und 14, der unteren Elektrode 6 sowie der Vias 4 und 13 wird das sogenannte Damascene-Verfahren angewandt.

Insbesondere wird zur Herstellung der Leiterbahnen 8 und 14, der unteren Elektrode 6 sowie der Vias 4 und 13 das Dual-Damascene-Verfahren verwendet.

Im Damascene-Verfahren wird beispielsweise zunächst das Trenndielektrikum 10 auf der auf einem Substrat aufliegenden Diffusionsbarriere 2 ganzflächig abgeschieden. Unter dem Substrat wird in diesem Zusammenhang sowohl ein homogener Grundkörper als auch ein Grundkörper mit einer Schichtstruktur verstanden. In das Trenndielektrikum 10 werden dann Gräben eingeätzt, die für die Leiterbahnen 3 vorgesehen sind. Durch konforme Abscheidung werden schließlich die Gräben mit einer leitenden Barriere 19 verkleidet. Die Barriere 19 dient in einer nachfolgenden Elektrolyse als Elektrode zur Abscheidung des Kupfers für die Leiterbahn 3.

Wie bereits erwähnt, werden die Leiterbahnen 8, die untere Elektrode 6 und die Vias 4 im Dual-Damascene-Verfahren hergestellt. Dazu wird zunächst das Zwischenlagendielektrikum 9 ganzflächig auf der Diffusionsbarriere 2 abgeschieden. Dann werden Gräben für die Leiterbahn 8 und die untere Elektrode 6 aus dem Zwischenlagendielektrikum 9 ausgeätzt. In einem weiteren Ätzvorgang werden diese Gräben an den Stellen, an denen die Vias 4 vorgesehen sind, weiter vertieft. Die so entstandenen Vertiefungen werden daraufhin mit einer Barriere 20 in konformer Abscheidung versehen. In der nachfolgenden Elektrolyse lagert sich dann an der Barriere 19, die als Elektrode dient, das abgeschiedene Kupfer an.

Auf der plananisierten Oberfläche findet schließlich eine ganzflächige Abscheidung der dielektrischen Zwischenschicht 11 und der für die obere Elektrode 12 vorgesehenen Metallisierungsschicht statt. Bei der für die obere Elektrode 12 vorgesehenen Metallisierungsschicht kann es sich um eine homogene Schicht aus einer Legierung oder auch einen Stapel aus Metallschichten und leitenden Barrieren handeln. Anschließend erfolgt die Strukturierung des Metall-Isolator-Metall-Kondensators 7 mit einem Ätzstop in der dielektrischen Zwischenschicht 11. Die dielektrische Zwischenschicht 11 bleibt somit auch außerhalb des Metall-Isolator-Metall-Kondensators 7 erhalten. Durch die weiträumige elektrische Trennung von oberer Elektrode 12 und unterer Elektrode 6 besteht nicht die Gefahr von Kurzschlüssen zwischen der unteren Elektrode 6 und der oberen Elektrode 12. Ein weiterer Vorteil ist, daß die dielektrische Zwischenschicht 11 und die obere Elektrode 12 auf einer planarisierten Oberfläche aufgebracht werden können. Dadurch ist die Planarität der dielektrischen Zwischenschicht 11 und der oberen Elektrode 12 gewährleistet.

Im Anschluß an die Ausbildung des Metall-Isolator-Metall-Kondensators 7 erfolgt die Abscheidung des Zwischenlagendielektrikums 16. Im Dual-Damascene-Verfahren werden dann die Leiterbahn 14 und die Vias 13 ausgebildet. Dabei übernehmen Barrieren 21 die Rolle der zur Abscheidung des Kupfers notwendigen Elektroden. Bei der Ausätzung der Gräben für die Vias 13 ist gleichzeitig auf der oberen Elektrode 12 des Metall-Isolator-Metall-Kondensators 7 und den Leiterbahnen 14 zu stoppen.

Als Material für die dielektrische Zwischenschicht 11 kommt beispielsweise Si₃N₄ oder SiO₂ in Frage. Für die dielektrische Zwischenschicht 11 sind darüber hinaus auch Materialien mit hoher Dielektrizitätskonstante wie Ta₂O₅ oder Bi₂Sr₃TiO₃ und BaₓSr₁₋ₓTiO₃ geeignet, wobei 0≤x≤1 gilt. Von besonderem Vorteil ist, daß das Ätzverhalten dieser Materialien nicht im einzelnen bekannt sein muß, da mitten in der dielektrischen Zwischenschicht 11 gestoppt wird. Für die obere Elektrode 12 eignen sich Ta und TaN, sowie Silizide und Materialien wie Ti, TiN, TiW, W und WNₓ, wobei 0≤x≤2 gilt. Für die obere Elektrode 12 sind ferner leitende Materialien wie Si, W, Cu, Au, Ag, Ti und Pt sowie Legierungen davon einsetzbar.

Bei einem abgewandelten, in der Zeichnung nicht dargestellen Ausführungsbeispiel ist die obere Elektrode 12 und die dialektrische Zwischenschicht 11 von einer Schutzschicht aus SiN abgedeckt. Diese Schutzschicht dient als Stop für die Ätzung der Vias 13 und verhindert, daß beim Ätzen der Vias 13 die obere Elektrode 12 angegriffen wird. Außerdem wird die obere Elektrode 12 zur Seite hin gekapselt und dadurch zusätzlich zur unteren Elektrode 6 hin isoliert.

Abschließend sei angemerkt, daß sich das vorgeschlagene integrierte Bauelement insbesondere für die Verwendung in der Hochfrequenztechnik eignet.

## Patentansprüche

1. Integriertes Bauelement mit Leiterbahnen (3, 8, 14) aus einer kupferhaltigen Legierung und einem Metall-Isolator-Metall-Kondensator (7),
**dadurch gekennzeichnet,**
daß der Kondensator (7) von einer ersten Elektrode (6) in einer Metallebene (5) für Leiterbahnen, einer zunächst als Ätzstop dienenden dielektrischen Zwischenschicht (11) und einer Metallisierungsschicht (12) gebildet ist.

2. Integriertes Bauelement nach Anspruch 1,
**dadurch gekennzeichnet,**
daß die dielektrische Zwischenschicht (11) zusätzlich als Diffusionsbarriere dient.

3. Integriertes Bauelement nach Anspruch 1 oder 2,
**dadurch gekennzeichnet,**
daß die Metallisierungsschicht (12) ein Stapel aus Metallschichten und leitenden Barrieren ist.

4. Integriertes Bauelement nach einem der Ansprüche 1 bis 3,
**dadurch gekennzeichnet,**
daß die Metallisierungsschicht (12) wenigstens ein Metall aus der Gruppe A1, Si, W, Cu, Au, Ag, Ti und Pt enthält.

5. Integriertes Bauelement nach einem der Ansprüche 1 bis 4,
**dadurch gekennzeichnet,**
daß die Leiterbahnen (3, 8, 14) und die erste Elektrode (6) zu einem Zwischenlagendielektrikum (9, 16) durch Barrieren (19, 20, 21) abgegrenzt sind.

6. Integriertes Bauelement nach Anspruch 3 oder 5,
**dadurch gekennzeichnet,**
daß die Barriere, (19, 20, 21) aus Elementen aus der Gruppe Ta, TaN, TiW, W, WNₓ, Ti, TiN oder Siliziden hergestellt sind, wobei 0≤x≤2 gilt.

7. Integriertes Bauelement nach einem der Ansprüche 1 bis 6,
**dadurch gekennzeichnet,**
daß die dielektrische Zwischenschicht (11) aus SiO₂ oder Si₃N₄ hergestellt ist.

8. Integriertes Bauelement nach einem der Ansprüche 1 bis 6,
**dadurch gekennzeichnet,**
daß die dielektrische Zwischenschicht (11) von einem dielektrischen Material mit einer Dielektrizitätskonstante > 80 gebildet ist.

9. Integriertes Bauelement nach Anspruch 8,
**dadurch gekennzeichnet,**
daß die dielektrische Zwischenschicht (11) aus einem Material aus der Gruppe Ta₂O₅, Bi₂Sr₃TiO₃ und BaₓSr₁₋ₓTiO₃ hergestellt ist, wobei 0≤x≤1 gilt.

10. Verfahren zur Herstellung eines integrierten Bauelements mit Leiterbahnen (3, 8, 14) aus einer kupferhaltigen Legierung und einem Metall-Isolator-Metall-Kondensator (7), bei dem zunächst eine in einem Zwischenlagendialektrikum (16) eingebettete erste Elektrode (6) ausgebildet wird,
**dadurch gekennzeichnet,**
daß oberhalb der ersten Elektrode (6) zunächst eine dielektrische Zwischenschicht (11) und dann eine Metallisierungsschicht (12) ganzflächig abgeschieden wird und
daß dann die Metallisierungsschicht (12) strukturiert wird.

11. Verfahren nach Anspruch 10,
**dadurch gekennzeichnet,**
daß die dielektrische Zwischenschicht (11) als Ätzstop verwendet wird.

12. Verfahren nach Anspruch 10 oder 11,
**dadurch gekennzeichnet,**
daß die erste Elektrode (6) in einem Damascene-Verfahren hergestellt wird.
